# EUROPEAN PATENT SPECIFICATION

(11) **EP 1 639 149 B1**
(45) Date of publication and mention of the grant of the patent: **04.11.2009**
(21) Application number: 04728724.8
(22) Date of filing: 21.04.2004
(51) Int. Cl.: C23C 14/22, C23C 14/24

(54) **A METHOD FOR FORMING A SUPERHARD AMORPHOUS CARBON COATING IN VACUUM**
VERFAHREN ZUR HERSTELLUNG EINER SUPERHARTEN BESCHICHTUNG AUS AMORPHEM KOHLENSTOFF IM VAKUUM
PROCEDE DE FORMATION D'UN REVETEMENT SUPER DUR EN CARBONE AMORPHE, SOUS VIDE

(30) Priority: 22.05.2003 RU 2003115309
(43) Date of publication of application: 29.03.2006
(73) Proprietor: Argor Aljba S.A., 6850 Mendrisio (CH)
(72) Inventor: KOLPAKOV, Alexandr Yakovlevich, Belgorod, 308034 (RU); INKIN, Vitaly Nikolaevich, Moscow, 129337 (RU); UKHANOV, Sergei Ivanovich, Moscow,129337 (RU)
(74) Representative: Zardi, Marco
(86) International application number: PCT/RU2004/000149
(87) International publication number: WO 2004/104263

(56) References cited:
- WO-A-98/54376
- CA-A1- 2 256 846
- RU-C1- 2 114 210
- TW-B- 483 945
- US-A- 5 763 087
- US-A1- 2002 031 465
- HANS-JOACHIM SCHEIBE ET AL: "Deposition of Superhard Amorphous Carbon Films by Pulsed Arc Sources" IEEE TRANSACTIONS ON PLASMA SCIENCE, IEEE SERVICE CENTER, PISCATAWAY, NJ, US, vol. 25, no. 4, 1 August 1997 (1997-08-01), XP011044865 ISSN: 0093-3813

## Description

### Technical field

The invention relates to the art of formation of superhard durable coatings in vacuum, in particular - to a method for forming a superhard amorphous carbon coating in vacuum.

### Background of the invention

A known method for forming stress relieved amorphous tetrahedrally - coordinated carbon films comprises depositing a graphite target onto a substrate using a pulsed laser to produce a carbon film having internal stresses over 6 GPa, and than annealing the film so produced at 500-750°C to reduce the internal stresses (see, e.g. US patent 6,103,305).

Said method is impracticable due to the high temperature of annealing the produced articles, which causes loss in strength of the materials an article has been made of, and, occasionally, in destruction of the articles so produced.

The most proximate teaching is a method for forming a superhard carbon coating into vacuum, comprising the steps of: placing an article in a vacuum chamber, which chamber is subsequently evacuated; treating a surface of the article with accelerated ions; applying, on the treated surface, a layer of a material that provides adhesion of subsequent layers; initiating a pulsed electric-arc discharge at a graphite cathode, and producing a pulsed stream of carbon plasma from a plurality of cathode spots that move along the cathode surface; condensing the carbon plasma in a predetermined region upon the article' surface to form a superhard amorphous carbon coating, the article temperature being maintained within the range of 200 to 450 K through controlling a repetition frequency of the electric-arc discharge pulses (see, e.g. RF patent 2,114,210).

Said method has an essential drawback consisting in that in the carbon coating to be formed, high internal compression stresses occur and result in warping of a substrate and delamination of the coating when it reaches a predetermined thickness.

### Summary of the invention

The basic object of the invention is to provide a method to form a superhard amorphous carbon coating in vacuum, which method would present the occurrence of high internal compression stresses that result in warping of a substrate and delamination of the coating when it reaches a predetermined thickness.

The object is attained through a method for forming a superhard amorphous carbon coating in vacuum, comprising the steps of:
placing an article into a vacuum chamber, and evacuating the treating a surface of the article with accelerated ions, applying a layer of a material that provides adhesion of subsequent layers on the treated surface, and initiating a pulsed electric-arc discharge at a graphite cathode, and producing a pulsed stream of carbon plasma from a plurality of cathode spots moved along the cathode surface, and then condensing the carbon plasma in a predetermined region upon the article surface to form a superhard amorphous carbon coating, the article temperature being maintained within the range of 200 to 450 K through controlling a repetition frequency of the electric-arc discharge pulses,
wherein according to the invention: at the step of forming the carbon coating the pulsed stream of carbon plasma has average energy of ions of 25-35 eV, and concentration of ions of 10¹²-10¹³ cm⁻³, axis of said stream being inclined at angle of 15-45° to predetermined surface of the article;
at the step of applying the coating, temperature change Δt of the article is maintained within the range of 50-100 K.

The temperature change Δt of the article is advantageously maintained through controlling the repetition frequency of the electric-arc discharge pulses.

The article temperature change Δt is usefully maintained by removal of heat from the article.

In the course of application of the coating, the article is advantageously rotated about the axis that extends through the point of intersection of the carbon plasma stream with the coating formation surface, and is perpendicular to that surface.

The inclination of the carbon plasma stream to the carbon coating formation surface is usefully set by positioning the carbon plasma source axis at the angle of 15-45° to the carbon coating formation surface.

The carbon plasma stream axis is advantageously set by subjecting the carbon plasma stream to magnetic field so that to determine the stream inclination to the carbon coating formation surface.

The inclination of the carbon plasma stream to the carbon coating formation surface is usefully changed within the range of 15-45° in the course of application of the carbon coating.

The inclination of the carbon plasma stream to the carbon coating formation surface is usefully changed within the range of 15-45° in the course of application of the carbon coating, periodically.

### Description of the preferred embodiments of the invention

A method for forming a superhard amorphous carbon coating in vacuum is carried out as follows.

Surface of an article is preliminarily prepared by a mechanical treatment, with subsequent degreasing. Then the article is placed into a vacuum chamber at a special device used for rotating the article therein, and the article is secured at said device. The chamber is evacuated to pressure of 1*10⁻³ Pa. The device for rotating is also used to remove heat from the article.

In case of treating dielectric articles, accelerated ions are accelerated ions of gases. Treatment of metallic articles further provides for treatment of their surface with the accelerated metal ions generated by an electric-arc plasma source having a titan cathode. The arc current is set to value of 70-80A, negative potential of 700-1500V being applied to articles to provide the electrostatic acceleration of the positive-charge ionic component of the plasma.

Then the negative potential is reduced to 50-100V, and a metal sublayer 100-500Å thick is applied. The metal can be selected from the group consisting of titan, chrome, zirconium, niobium, tungsten.

Then a graphite cathode is sputtered by electric arc in vacuum to produce a carbon plasma stream accelerated in the near-cathode area and in the inter-electrode cathode-anode spacing and oriented such that its axis is inclined to the carbon coating formation surface at angle of 15-45°C.

In the course of sputtering, the article is rotated about the axis that is perpendicular to the coating formation surface. For sputtering a graphite cathode, used is a pulsed vacuum-arc discharge that has the following parameters: voltage 300V across a capacitor bank having capacity of 2000 µF; discharge duration 0.7-1.0 ms; discharge pulse repetition frequency 1-20 Hz. The cathode spots, emerging and moving along the graphite cathode surface, generate the carbon plasma whose ions with a predetermined discharge pulse duration have average energy of 25-35 eV, their concentration being 10¹²-10¹³ cm⁻³. The carbon plasma, being condensed on the article surface, forms a homogeneous amorphous structure consisting of variously oriented groups-clusters, wherein carbon atoms have the tetrahedric orientation and the bonds that are characteristic of diamond. The energy characteristics of carbon ions and the substrate temperature exert the decisive influence on properties of the produced coatings, more specifically - on formation of the covalent bonds among carbon atoms.

Bombardment of the carbon condensate surface by carbon ions having average energy of 25-35 eV results in formation, on the substrate whose temperature does not exceed 450 K, of a superhard carbon coating having the diamond-type bonds among carbon atoms.

The internal compression stresses in hard carbon condensates are of the structural nature and caused by processes of formation and evolution of defects of various kinds, of which defects the main ones are the radiation-induced defects. The lower limit of the average energy of carbon ions is equal to the threshold energy of carbon atomic displacement - 25 eV. When said energy exceeds 35 eV, this excess results in accumulation, in the condensate, of vacancies and vacancy complexes that result in "swelling", i.e. an increase of the carbon condensate volume and an increase of a value of internal stresses therein.

By controlling the angle of incidence of ions on surface of the growing carbon condensate, the value of the internal compression stresses in the coating can be substantively diminished by reducing the number of the radiation-induced defects in the condensate. At that, the carbon ions, hitting the growing condensate surface at angle of 15-45°C, will remove atoms and atomic groups retained on the surface by weak Van der Waals forces and result in formation of the diamond-type bonds on the surface.

The carbon ions' stream directed normally to the formed condensate results in formation of the in-depth heterogeneous distribution of the radiation-induced defects. The surface layer about 0.2-0.4 nm thick is congested with vacancies. The inter-node carbon atoms having a lesser migration energy (about 0.1 eV) penetrate into a greater depth, which circumstance results in consolidation of the growing condensate, but simultaneously results in development of the internal compression stresses in the formed carbon condensate. Formation of the carbon coating from the carbon plasma pulsed stream having average ion energy of 25-35 eV and whose axis is inclined to the carbon coating formation surface at angle of 15-45°C, allows adjusting the value of the ion energy normal component, reducing the a number of the radiation-induced defects formed in depth and correspondingly lowering the level of the internal compression stresses within the coating.

But when values of the inclination are less than 15°, the condensation rate substantially falls due to an increased number of the carbon ions reflected from the surface. When the inclination of the carbon ion stream to the coating formation surface is over 45°, the value of the ion energy normal component exceeds the tangential component value, which results in an intense growth of the internal compression stresses within the carbon condensate due to accumulation of the radiation-induced defects in the coating depth.

The internal stresses within the carbon coating can be further reduced by controlling the pulse repetition frequency such that the article temperature change during application of the coating will not be higher than 100 K. As temperature of the article substrate, on whose surface the coating is formed, rises, the proportion of the atoms, that develop the graphite-characteristic bonds among them, becomes larger. Thus, when the temperature change of an article is over 100 K, structure of the carbon condensate formed in the initial condensation process stage will differ from the structure of coating formed at higher temperatures, this circumstance will result in a greater volume of the condensate and, accordingly, in an higher value of the internal compression stresses therein. Thus, keeping the temperature range change of an article within 100 K will allow the structural homogeneity of the carbon coating and minimal level of the internal compression stresses to be provided.

For improvement of the in-thickness homogeneity of the coating, the inclination of the carbon plasma stream to the carbon coating formation surface is set by subjecting the carbon plasma stream to magnetic field.

To provide a carbon coating having various values of the internal stresses, the inclination of the carbon plasma stream to the carbon coating formation angle is changed during application of the carbon coating using magnetic field within the range of 15-45°.

### Example 1

A specimen, such as a fresh cleavage of mono-crystalline NaCl, was secured in an appropriate device and positioned at angle of 30° with respect to the carbon plasma stream. The carbon film 30 nm thick was applied by electric-arc sputtering a graphite cathode in the pulsed discharge, with the following parameters: voltage across a capacitor bank having capacity of 2000 µF was 300V; discharge pulse duration was 0.75 ms; discharge pulse repetition frequency was 1 Hz. Under these conditions, average energy of carbon ions was 35 eV. The initial temperature of the specimen was 293 K, final temperature - 313 K. The specimen temperature change in the course of application of the carbon film was 20 K. The carbon films, after their separation from mono-crystalline NaCl, were studied by the method of clearance diffraction of electrons and 3 amorphous halos were detected. For the detailed structural study of the short-range ordering in atomic arrangement of carbon atoms, angular distributions of electron scattering intensity were measured, and the atomic radial distribution function was built. Structure simulation by Monte Carlo method resulted in a 3-D model of the amorphous carbon film structure. It was determined that the tetrahedrons characteristic of the diamond structure underlay the structure.

### Example 2

A polished specimen of a hardened carbon steel with dimensions of 20×20×10 mm was used; the specimen was secured on a special device serving for removal of heat and positioned in a vacuum chamber at angle of 45° to the carbon plasma stream. The specimen was placed into the vacuum chamber, and the chamber was evacuated to pressure of 10⁻³ Pa. The specimen was treated by titan ions generated by an electric-arc source of titan plasma, wherein a consumable cathode made of titan was used. The titan ions were accelerated electro-statically by application of the accelerating negative potential of 1000 V to said device. The arc current was set to 75 A. Duration of the treatment was 3 min. Then the potential was decreased to 70 V, and titan layer 50 nm thick was applied. After that, the carbon layer 5 µm thick was applied without delivery of a potential across the specimen by way of the pulsed vacuum-arc sputtering of a graphite cathode, with the following parameters: voltage across a capacitor bank having capacity of 2000 µF was 300V; discharge duration was 0.75 ms; discharge pulse repetition frequency was 10 Hz. At that, average energy of carbon ions was 35 eV, temperature of the specimen during application of the carbon coating was changed by 100 K from 343 K to 443 K.

Vickers microhardness was HV 7000, the load applied on the indentor was 50 g.

### Example 3

A specimen, a silicone plate, was secured on a rotating arrangement in a vacuum chamber in the horizontal plane. The chamber was evacuated to pressure of 10⁻³ Pa. The plate surface was treated by the accelerated argon ions with the following discharge parameters: discharge current - 100 mA, discharge voltage - 2000V, treatment time - 1.5 min. Then the carbon layer 170 nm thick was applied by electric-arc pulse sputtering, with the following parameters: voltage across a capacitor bank having capacity of 2000 µF was 300V; discharge pulse duration was 1.0 ms; discharge pulse repetition frequency was 3 Hz. Under these conditions, average energy of carbon ions was 25 eV. The carbon plasma beam was deflected by magnetic field at angle of 15° to the carbon condensate formation surface.

The internal compression stress in the carbon condensate was 0.5 GPa as determined basing on the value of deformation of the silicone plate. The coating so produced had no delamination.

### Example 4

As the specimen used was 99.99 pure gold ingot of definite dimensions bearing, on one of its sides, a holographic stamped microrelief. Said ingot was secured on a rotating device in a vacuum chamber in the horizontal plane. The chamber was evacuated to pressure of 10⁻³ Pa. The ingot surface was treated by the accelerated argon ions with the following discharge parameters: discharge current - 100 mA, discharge voltage - 2000V, treatment time - 30 s. Then the carbon layer 120 nm thick was applied by electric-arc pulse sputtering of a carbon cathode, with the following parameters: voltage across a capacitor bank having capacity of 2000 µF was 300V; discharge pulse duration was 0.75 ms; discharge pulse repetition frequency was 3 Hz. Under these conditions, average energy of carbon ions was 35 eV. The carbon plasma beam was deflected by magnetic field at angle of 15° to the carbon condensate formation surface.

The standard abrasion test demonstrated the 10-fold improvement of resistance to abrasion of the holographic relief.

### Industrial applicability

The invention can be suitably used for the purpose to extend the service life of the cutting, shaping, measuring tools, parts of assemblies subjected to friction, parts of the precision engineering assemblies; to protect a microrelief, including holographic or diffraction microrelief, against wear; in medicine - to improve biological compatibility of implants owing to better surface properties; in electronics - to extend service life of video- and audio heads, as well as of the hard magnetic discs owing to an increased hardness of surface and reduced friction factor; in acoustics - to improve characteristics of acoustic membranes; as coatings for the infrared-region optical components, and also as decorative coatings.

## Claims

1. A method for forming a superhard amorphous carbon coating in vacuum, comprising the steps of:
placing an article in a vacuum chamber and evacuating the chamber;
treating a surface of the article with accelerated ions;
applying a layer of a material that provides adhesion of subsequent layers on the treated surface;
initiating a pulsed electric-arc discharge at a graphite cathode, and producing a pulsed stream of carbon plasma from a plurality of cathode spots moved along the cathode surface;
condensing the carbon plasma in a predetermined region upon the article surface to form a superhard amorphous carbon coating, the article temperature being maintained within the range of 200 to 450 K through controlling a repetition frequency of the electric-arc discharge pulses;
**characterized in that**
at the step of forming the carbon coating the pulsed stream of carbon plasma has average energy of ions of 23-35 eV and concentration of ions of 10¹²-10¹³ cm⁻³, axis of said stream of carbon plasma being inclined at angle of 15-45° to a predetermined surface of the article;
at the step of applying the coating, a temperature change Δt of the article is maintained within the range of 50-100 K.

2. The method as claimed in claim 1, **characterized in that** the article temperature change Δt is maintained through controlling the repetition frequency of the electric-arc discharge pulses.

3. The method as claimed in claim 1, **characterized in that** the article temperature change Δt is maintained by removal of heat from the article.

4. The method as claimed in claim 1, **characterized in that** in the course of application of the coating, the article is rotated about the axis extending through the point of intersection of the carbon plasma stream axis with the coating formation surface, and being perpendicular to said surface.

5. The method as claimed in claim 1, **characterized in that** the inclination of the carbon plasma stream to the carbon coating formation surface is set by positioning the carbon plasma source axis at angle of 15-45° to the carbon coating formation surface.

6. The method as claimed in claim 1, **characterized in that** the carbon plasma stream axis is set by subjecting the carbon plasma stream to magnetic field so that to predetermine the stream inclination angle to the carbon coating formation surface.

7. The method as claimed in claim 6, **characterized in that** the inclination of the carbon plasma stream to the carbon coating formation surface is changed in the course of application of the carbon coating within the range of 15-45°.

8. The method as claimed in claim 6, **characterized in that** the inclination of the carbon plasma stream to the carbon coating formation surface is periodically changed in the course of application of the carbon coating within the range of 15-45°.

## Patentansprüche

1. Verfahren zur Bildung einer superharten, amorphen Kohlenstoffbeschichtung unter Vakuum, die Schritte umfassend:
Einlegen eines Gegenstandes in eine Vakuumkammer und Leerpumpen der Kammer;
Behandeln einer Oberfläche des Gegenstandes mit beschleunigten Ionen;
Auftragen einer Schicht aus einem Material, das für ein Anhaften nachfolgender Schichten an der behandelten Fläche sorgt;
Auslösen einer gepulsten Lichtbogenentladung an einer Graphitelektrode und Erzeugen eines gepulsten Strahls aus Kohlenstoffplasma aus einer Vielzahl von Kathodenbrennflecken, die sich entlang der Kathodenoberfläche bewegen;
Kondensieren des Kohlenstoffplasmas in einem vorbestimmten Bereich auf der Oberfläche des Gegenstands, um eine superharte amorphe Kohlenstoffbeschichtung zu bilden, wobei die Temperatur des Gegenstandes durch Steuern einer Wiederholfrequenz der Lichtbogenentladungsimpulse innerhalb des Bereichs von 200 bis 450 K gehalten wird,
**dadurch gekennzeichnet, dass**
beim Schritt des Bildens der Kohlenstoffbeschichtung der gepulste Strahl aus Kohlenstoffplasma eine mittlere Ionenenergie von 23 bis 35 eV und eine Ionenkonzentration von 10¹² bis 10¹³ cm⁻³ hat, wobei die Achse des Strahls aus Kohlenstoffplasma zu einer vorbestimmten Fläche des Gegenstandes unter einem Winkel von 15 bis 45° geneigt ist;
beim Schritt des Auftragens der Beschichtung eine Temperaturänderung ΔT des Gegenstandes innerhalb des Bereichs von 50 bis 100 K gehalten wird.

2. Verfahren nach Anspruch 1, **dadurch gekennzeichnet, dass** die Temperaturänderung ΔT des Gegenstandes durch Steuern der Wiederholfrequenz der Lichtbogenentladungsimpulse eingehalten wird.

3. Verfahren nach Anspruch 1, **dadurch gekennzeichnet, dass** die Temperaturänderung ΔT des Gegenstandes durch Abziehen von Wärme vom Gegenstand eingehalten wird.

4. Verfahren nach Anspruch 1, **dadurch gekennzeichnet, dass** im Verlauf des Auftragens der Beschichtung der Gegenstand um die Achse gedreht wird, die durch den Schnittpunkt der Kohlenstoffplasma-Strahlachse mit der Beschichtungsbildungsfläche verläuft und senkrecht zu dieser Fläche steht.

5. Verfahren nach Anspruch 1, **dadurch gekennzeichnet, dass** die Neigung des Kohlenstoffplasmastrahls zur Kohlenstoffbeschichtungs-Bildungsfläche durch Anordnen der Achse der Kohlenstoffplasmaquelle unter einem Winkel von 15 bis 45° zur Kohlenstoffbeschichtungs-Bildungsfläche eingestellt wird.

6. Verfahren nach Anspruch 1, **dadurch gekennzeichnet, dass** die Kohlenstoffplasma-Strahlachse eingestellt wird, indem der Kohlenstoffplasmastrahl einem Magnetfeld so unterworfen wird, dass der Strahlneigungswinkel zur Kohlenstoffbeschichtungs-Bildungsfläche vorbestimmt ist.

7. Verfahren nach Anspruch 6, **dadurch gekennzeichnet, dass** die Neigung des Kohlenstoffplasmastrahls zur Kohlenstoffbeschichtungs-Bildungsfläche im Verlauf des Auftragens der Kohlenstoffbeschichtung innerhalb des Bereichs von 15 bis 45° verändert wird.

8. Verfahren nach Anspruch 6, **dadurch gekennzeichnet, dass** die Neigung des Kohlenstoffplasmastrahls zur Kohlenstoffbeschichtungs-Bildungsfläche im Verlauf des Auftragens der Kohlenstoffbeschichtung innerhalb des Bereichs von 15 bis 45° periodisch verändert wird.

## Revendications

1. Procédé pour former un revêtement en carbone amorphe ultra dur sous vide, comportant les étapes consistant à :
placer un article dans une chambre à vide et faire le vide dans la chambre,
traiter une surface de l'article à l'aide d'ions accélérés,
appliquer une couche dun matériau qui assure l'adhérence de couches ultérieures sur la surface traitée,
déclencher une décharge d'arc électrique pulsé sur une cathode en graphite, et produire un flux pulsé de plasma de carbone à partir d'une pluralité de taches cathodiques déplacées le long de la surface cathodique,
condenser le plasma de carbone dans une zone prédéterminée sur la surface de l'article afin de former un revêtement en carbone amorphe ultra dur, la température de l'article étant maintenue dans la plage de - 73 à 177 °C (200 à 450 K) en commandant une fréquence de répétition des impulsions de décharge d'arc électrique,
**caractérisé en ce que**
à l'étape de formation du revêtement en carbone, le flux pulsé de plasma de carbone a une énergie moyenne d'ions de 23 à 35 eV et une concentration d'ions de 10¹² à 10¹³ cm⁻³, l'axe dudit flux de plasma de carbone étant incliné à un angle de 15 à 45 ° par rapport une surface prédéterminée de l'article,
à l'étape d'application du revêtement, une variation de température AT de l'article est maintenue dans la plage de - 223 à -173 °C (50 à 100 K).

2. Procédé selon la revendication 1, **caractérisé en ce que** la variation de température ΔT de l'article est maintenue en commandant la fréquence de répétition des impulsions de décharge d'arc électrique.

3. Procédé selon la revendication 1, **caractérisé en ce que** la variation de température ΔT de l'article est maintenue par évacuation de la chaleur de l'article.

4. Procédé selon la revendication 1 **caractérisé en ce qu'**au cours de l'application du revêtement, l'article est tourné autour de l'axe s'étendant par le point d'intersection de l'axe du flux de plasma de carbone avec la surface de formation du revêtement, et étant perpendiculaire à ladite surface.

5. Procédé selon la revendication 1, **caractérisé en ce que** l'inclinaison du flux de plasma de carbone par rapport à la surface de formation du revêtement en carbone est réglée en positionnant l'axe de la source de plasma de carbone à un angle de 15 à 45 ° par rapport à la surface de formation du revêtement en carbone.

6. Procédé selon la revendication 1, **caractérisé en ce que** l'axe du flux de plasma de carbone est réglé en soumettant le flux de plasma de carbone à un champ magnétique de manière à prédéterminer l'angle d'inclinaison du flux par rapport à la surface de formation du revêtement en carbone.

7. Procédé selon la revendication 6, **caractérisé en ce que** l'inclinaison du flux de plasma de carbone par rapport la surface de formation du revêtement en carbone est changée au cours de l'application du revêtement en carbone dans la plage de 15 à 45 °.

8. Procédé selon la revendication 6, **caractérisé en ce que** l'inclinaison du flux de plasma de carbone par rapport à la surface de formation du revêtement en carbone est périodiquement changée au cours de l'application du revêtement en carbone dans la plage de 15 à 45 °.
